(19) Europäisches Patentamt / European Patent Office / Office européen des brevets

(11) **EP 2 444 770 B1**

(12) **EUROPEAN PATENT SPECIFICATION**

(45) Date of publication and mention of the grant of the patent:
**12.02.2020 Bulletin 2020/07**

(51) Int Cl.:
*F28D 15/02* *(2006.01)*   *F28D 1/053* *(2006.01)*
*F28F 9/02* *(2006.01)*

(21) Application number: **10188165.4**

(22) Date of filing: **20.10.2010**

(54) **Heat Exchanger Based on Pulsating Heat Pipe Principle**

Wärmetauscher nach dem Prinzip des pulsierenden Wärmerohrs

Échangeur de chaleur comprenant un caloduc pulsatif

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.04.2012 Bulletin 2012/17**

(73) Proprietor: **ABB Schweiz AG**
**5400 Baden (CH)**

(72) Inventors:
• **Agostini, Bruno**
**8953, Dietikon (CH)**

• **Fabbri, Matteo**
**8134, Adliswil (CH)**

(74) Representative: **Kolster Oy Ab**
**(Salmisaarenaukio 1)**
**P.O. Box 204**
**00181 Helsinki (FI)**

(56) References cited:
**EP-A1- 2 031 332      EP-A1- 2 327 947**
**WO-A1-03/054467      WO-A2-2010/055542**
**FR-A1- 2 407 445      US-A1- 2003 037 910**

**Description**

## BACKGROUND OF THE INVENTION

### FIELD OF THE INVENTION

This invention relates to a heat exchanger and in particular to an improved heat exchanger suitable for use in cooling electronic apparatuses.

### DESCRIPTION OF PRIOR ART

Previously there is known from EP - A - 2 031 332 a heat exchanger with evaporator channels and condenser channels extending between a first and a second end of the heat exchanger. The opposite ends of the heat exchanger are provided with connecting parts that provide fluid paths between the evaporator channels and the condenser channels. A first heat transfer element is arranged in a vicinity of the first end of the heat exchanger for transferring a heat load to a fluid in said evaporator channels. Similarly, a second heat transfer element is arranged in a vicinity of the second end of the heat exchanger for transferring a heat load from a fluid in said condenser channels to surroundings. The above described heat exchanger is very efficient in cooling down, for instance, power electronics attached to the first heat transfer element. Due to a construction of thermosyphon type, cooling can be achieved without a need for a pumping unit. A drawback with the above described solution is, however, that the heat exchanger needs to be installed in a specific position in order to work properly. Such a restriction is problematic, because in some implementations it would be advantageous to be able to install the heat exchanger in an upside down or horizontal position.

The EP publication 2 327 947 A, which has been published after filing of the present application, discloses a heat exchanger with groups of channels and fluid connecting parts in opposite ends of the channels that conduct fluid between predetermined channels. In this way the heat exchanger can work as a pulsating heat pipe. In this solution the connecting parts are implemented with manifolds and fluid distribution elements manufactured as separate parts which can be inserted in the manifolds.

Previously there is also known from WO 03/054467 A1 a heat exchanger suitable to be used as an evaporator for a motor vehicle and therefore comprising only one heat transfer element, and from WO 2010/055542 A2 a heat exchange device made of polymeric material.

## SUMMARY OF THE INVENTION

An object of the present invention is to solve the above mentioned drawback and to provide an efficient and cheap heat exchanger which is less sensitive regarding the position in which the heat exchanger is installed. This and other objects of the invention are achieved with a heat exchanger as defined in independent claim 1.

The heat exchanger comprises at least a first and second group of channels having capillary dimensions, and fluid distribution elements at the opposite ends. The first and second heat transfer elements are in contact with all the channels of the first and second group of channels in order to transfer heat load to fluid in the channels and, respectively, from the fluid in the channels. This enables the heat exchanger to work as a Pulsating Heat Pipe (PHP). In such a solution involving channels having capillary dimensions, oscillations occur in a small channel loop heat pipe due to the bidirectional expansion of vapour inside the channels. Consequently, the heat exchanger works in any orientation, without significant additional costs, and with a fluid volume that is smaller as compared to other solutions.

Preferred embodiments of the invention are disclosed in the dependent claims.

## BRIEF DESCRIPTION OF DRAWINGS

In the following the present invention will be described in greater detail by way of example and with reference to the attached drawings, in which

    Figure 1 illustrates a first embodiment of a heat exchanger,
    Figure 2 illustrates a first fluid distribution element,
    Figure 3 illustrates a second fluid distribution element,
    Figure 4 illustrates a first heat transfer element,
    Figure 5 illustrates the function of the heat exchanger, and
    Figure 6 illustrates a heat exchanger outside the scope of the invention.

## DESCRIPTION OF AT LEAST ONE EMBODIMENT

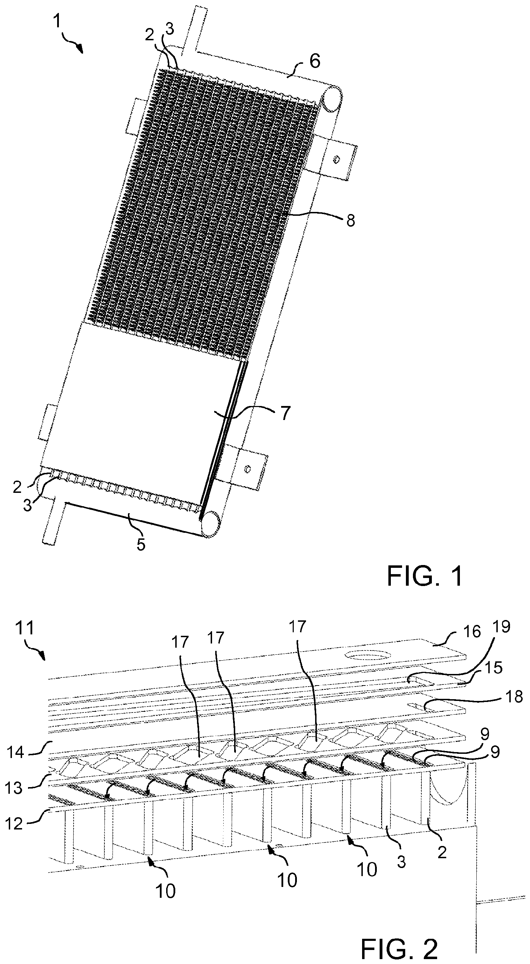

Figure 1 illustrates a first embodiment of a heat exchanger 1. The heat exchanger 1 comprises at least a first group 2 of channels and a second group 3 of channels extending between a first and a second end of the heat exchanger 1. A first connecting part 5 is arranged at a first end of the heat exchanger 1 for providing a fluid path between channels of the first 2 and the second 3 group of channels, as will be explained later. A second connecting part 6 is arranged at a second end of the heat exchanger 1.

In the illustrated example there are more than two groups of channels. These channels have capillary dimensions. In this context "capillary dimensions" refers to channels that are capillary-sized, in which case they have a size small enough so that bubbles can grow uniquely in a longitudinal direction (in other words in the longitudinal direction of the channel as opposed to the radial direction) and thereby create a pulsating effect by pushing the liquid.

The heat exchanger also comprises a first heat transfer element 7 arranged in a vicinity of the first end of the heat exchanger 1, for transferring a heat load to a fluid in the channels of said at least first 2 and second 3 group of channels. The heat exchanger of Figure 1 is preferably used in an electronics apparatus, such as in a frequency converter, for conducting heat away from components generating a significant heat load. In that case, electronic circuits can be attached to the first heat transfer element 7. The heat transfer element 7 transfers said heat load to fluid in all channels of said at least first 2 and second 3 group of channels. This can be achieved such that the first heat transfer element 7 is in contact with each one of the channels.

The heat exchanger 1 also comprises a second heat transfer element 8, which in the illustrated embodiments, consists of fins extending between walls of channels of the first 2 and second 3 group of channels in order to transfer heat from fluid inside the heat exchanger 1 to surroundings. In this way the heat load can be transferred from fluid in all channels to the fins and further from the fins to the air surrounding the second heat transfer element 8.

Figure 2 illustrates a first fluid distribution element 11. The first fluid distribution element 11 of Figure 2 may be utilized inside the first connecting part 5 of the heat exchanger 1 shown Figure 1, for instance.

The channels 9 extending between the first and second ends of the heat exchanger 1 are grouped together into at least a first 2 and a second 3 group, each group including a plurality of channels 9. In the illustrated embodiment, the heat exchanger 1 comprises a plurality of parallel pipes 10 extending between the first end and the second end of the heat exchanger 1. These pipes 10 have been divided into channels 9 by internal walls of the pipes 10. Thus, each pipe 10 contains channels 9 of one group of channels. The pipes 10 or tubes may be MPE (MultiPort Extruded) pipes, for instance.

The channels 9 have capillary dimensions. In this example they are capillary-sized so that no additional capillary structures are needed on their internal walls. The diameter of a channel or tube which is considered capillary depends on the fluid that is used (boiling) inside. The following formula, for instance, can be used to evaluate a suitable diameter:

$$D = (sigma/(g*(rhol-rhov)))^{0.5},$$

wherein sigma is the surface tension, g the acceleration of gravity, rhov the vapour density and rhol the liquid density. This formula gives values from 1 to 3 mm for R134a (Tetrafluoroethane), R145fa and R1234ze (Tetrafluoropropene), which are fluids suitable for use in the heat exchanger illustrated in the figures. The length of the illustrated heat exchanger can be from about 20 cm to 2 m or even more.

The first fluid distribution element 11 is arranged to conduct fluid from one or more predetermined channels 9 of the first group of channels 2 into one or more predetermined channels 9 of said second group of channels 3. In the illustrated example the first fluid distribution element 11 has been implemented by a plurality of plates 12 to 15, some of said plates comprising openings for providing fluid paths between channels 9 of the groups of channels.

The lowest plate 12 is provided with openings that tightly surround the pipes 10. The following plate 13 is arranged on top of the lowest plate 12, and is provided with openings 17 which allow fluid to pass from predetermined channels of the first group 2 of channels to predetermined channels of the second group 3 of channels, as indicated by arrows in Figure 2. As Figure 2 illustrates an example with more than two groups of channels, the openings 17 allow fluid to pass from predetermined channels of a group to predetermined channels of an adjacent group for all illustrated groups. Flow is possible only to or from such channels 9 whose openings are located at the openings 17 of the plate 13. Flow to or from other channels 9 is blocked by the lower surface of plate 13.

The third plate 14 is arranged as a lid on top of the plate 13 in order to ensure that a flow of fluid takes place only where the openings 17 of the plate 13 are located. However, the third plate 14 also comprises two holes 18 (in this example) located at the outermost pipes 10 of the heat exchanger. In Figure 2 only one of the holes 18 is shown. In this way the third plate 14 in cooperation with the hole 19 in the fourth plate 15 defines a channel, which makes it possible for fluid to flow from one or more predetermined channels of the pipe located outermost to the left to one or more predetermined channels of the pipe located outermost to the right, and vice versa. The presence of such a channel will cause the heat exchanger to behave like a closed loop pulsating heat pipe.

Finally the uppermost plate 16 is arranged as a lid on top of the fourth plate 15 in order to prevent leakage from the channel defined by the opening 19. In the illustrated example, though not necessarily in all embodiments, the uppermost plate 16 is provided with an opening that can be connected to a pipe and a valve for the purpose of filling or emptying the heat exchanger when necessary. In addition this opening can be used for pressure and/or temperature measurements, for instance.

As an alternative to the illustrated embodiment, plates 14 and 15 can be removed from Figure 2. In that case, no flow path exists between the channels of the leftmost and rightmost pipes 10. Consequently, the heat exchanger works as an open loop pulsating heat pipe.

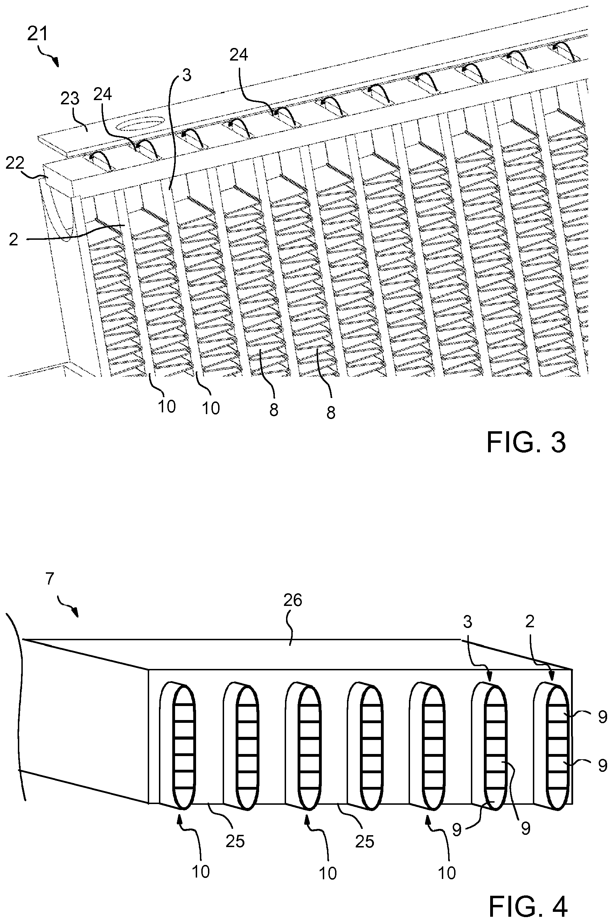

Figure 3 illustrates a second fluid distribution element. The second fluid distribution element 21 of Figure 3 may be utilized inside the second connecting part 6 of the heat exchanger 1 shown Figure 1, for instance.

The second fluid distribution element 21 conducts fluids between channels 9 that belong to the same group, as indicated by arrows in Figure 3. Consequently, the second fluid distribution element 21 conducts fluid from one or more channels 9 of any group (2, 3) into one or more channels 9 of the same group.

In the illustrated embodiment the second fluid distribution element 21 is implemented with two plates 22 and 23 by way of example. The fist plate 22 is provided with openings 24 which tightly surround the pipes 10 containing the groups 2, 3 of channels and which provide fluid paths between channels 9 within each group of channels. Plate 23 is arranged on top of plate 22 as a lid. In the illustrated example, though not necessarily in all embodiments, plate 23 is provided with an opening that can be connected to a pipe and a valve for the purpose of filling or emptying the heat exchanger when necessary. In addition this opening can be used for pressure and/or temperature measurements, for instance.

Figure 3 also illustrates the second heat transfer element 8, which in this example comprises fins extending between walls of the pipes 10. The fins have been dimensioned to contact the pipes 10 along their entire side surfaces. Consequently, the second heat transfer element 8 is arranged to transfer heat load from fluid in all channels 9 of the groups of channels contained in pipes 10.

Figure 4 illustrates a first heat transfer element 7. This first heat transfer element 7 may be utilized in the heat exchanger of Figure 1.

The heat transfer element 7 basically consists of a block of a material with a good heat conductivity. Suitable materials include metals, such as aluminum, for instance. The same material or another material with good heat conductivity may be used for the pipes. In Figure 4, the upper flat surface 26 may be utilized for attaching electronic components that require an efficient cooling, for instance. The lower surface 25 is provided with grooves into which tubes 10 have been arranged. Each tube contain channels 9 of one group of channels, such as channels 9 of the first 2 or second 3 group of channels. The grooves are deep enough for the first heat transfer element 7 to contact the entire side walls of the tubes 10. Therefore, the first heat transfer element 7 receives a heat load from all the channel 9 included in the illustrated groups of channels.

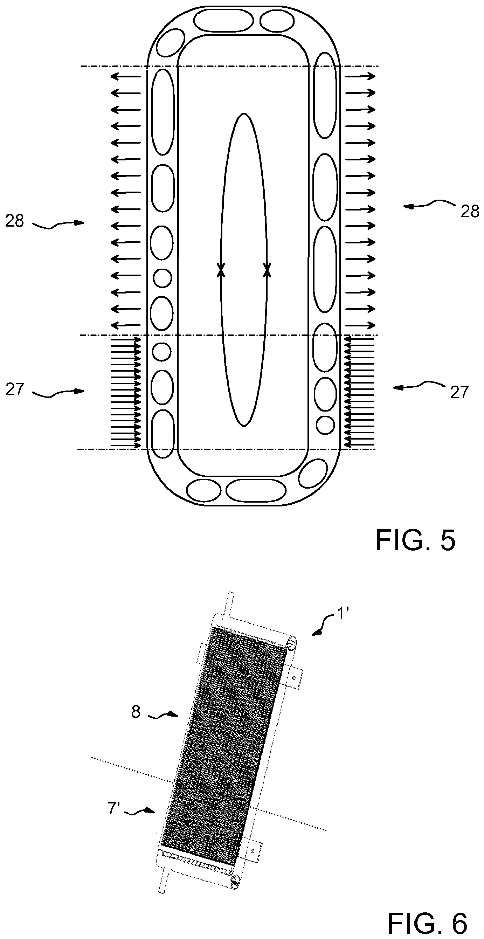

Figure 5 illustrates the function of the heat exchanger constructed according to Figures 1 to 4.

The heat exchanger 1 has a construction resembling the construction of a Compact Thermosyphon Heat Exchanger (COTHEX). However, the channels have capillary dimensions and the connecting parts of the first and the second end are provided with fluid distribution elements that conduct fluid from predetermined channels between the different groups of channels. This makes it possible to have the heat exchanger work as a Pulsating Heat Pipe (PHP). In such a solution, oscillations occur in a small channel loop heat pipe due to the bidirectional expansion of vapour inside the channels. During operation, the liquid slugs and elongated vapour bubbles will oscillate between a cold and a hot region because of hydrodynamic instabilities caused by the rapid expansion of the bubbles confined in the small channels, and thus provide a fluid velocity almost independent of gravity. Consequently, the heat exchanger illustrated in the figures works in any orientation (with some performance changes depending on the orientation, however). There is no preferred flow direction due to the occurrence of the periodic oscillations and, therefore, no need for a riser and a downcomer.

In Figure 5 the lower part 27 of the heat exchanger, where the first heat transfer element is located, works as an evaporator receiving a heat load and transferring it into fluid in channels of the heat exchanger. The upper part 28 of the heat exchanger, where the second heat transfer element is located, works as a condenser transferring heat load from fluid in the channels of the heat exchanger to the surroundings. However, it should be observed that "lower" and "upper" in this context only refers to the position of the heat exchanger as shown in Figure 5 by way of example, as the heat exchanger may also be used in an upside-down position as compared with the example illustrated in Figure 5. No pump is needed in order to transfer fluid within the heat exchanger, as the heat exchanger works as a pulsating heat pipe. In addition, no separate condenser pipes, evaporator pipes, risers or down-comers to/from the condenser or the evaporator is needed. Consequently, the fluid volume is relatively small even though an efficient cooling can still be achieved.

Figure 6 illustrates an alternative heat exchanger 1' which is outside the scope of the claimed invention. The heat exchanger of Figure 6 is very similar to the one illustrated in Figure 1. Therefore the heat exchanger of Figure 6 will be mainly explained mainly by referring to the differences between these embodiments.

In Figure 1, the first heat transfer element 7 is presented as a plate where electronic circuits can be attached. In that way heat is conducted from the plate to the channels containing fluid. In Figure 6, however, the first heat transfer element 7' comprises fins extending between walls of the channels. Therefore, heat from the surroundings of the first heat transfer element 7' is transferred via the fins to the fluid in the channels. A hot airstream may be generated to pass via the fins of the first heat transfer element 7' in order to obtain a sufficient heat transfer, if necessary. A similar cold airstream may also be utilized in order to transfer heat away from the second heat transfer element 8 in this embodiment as well as in the previously explained embodiments.

The fins of the first heat transfer element 7' and of the second heat transfer element 8 may be shaped and arranged in an identical way, for instance as illustrated in Figure 3, such that the fins contact the entire side walls of the pipes 10 containing the groups of channels 9.

It is to be understood that the above description and the accompanying figures are only intended to illustrate the present invention. It will be obvious to a person skilled in the art that the invention can be varied and modified within the terms and scope of the appended claims. In particular, it should be observed that the design of the distribution elements is only provided as an example as other designs are possible.

## Claims

1. A heat exchanger (1; 1') comprising:

   at least a first group (2) and a second group (3) of channels arranged to provide fluid paths between a first end and a second end of said heat exchanger (1; 1'), said channels (9) being capillary dimensioned for the used fluid and connected to each other by a first and a second fluid distribution element (11, 21) conducting fluid from predetermined channels between the different groups,
   a first heat transfer element (7) arranged in a vicinity of said first end to work as an evaporator for transferring a heat load to fluid in all channels (9) of said at least first (2) and second (3) groups of channels, wherein said first heat transfer element (7) comprises a first surface (26) for receiving electronic components and a second surface (25) with grooves for contacting walls of said channels (9) in order to transfer heat generated by said electronic components to said fluid in said channels (9),
   a second heat transfer element (8) arranged in a vicinity of said second end to work as a condenser for transferring a heat load away from said fluid in all channels (9) of said at least first (2) and second (3) groups of channels,
   a first connecting part (5) arranged at said first end of said heat exchanger (1; 1') and which comprises the first fluid distribution element (11) is arranged to conduct fluid from one or more predetermined channels (9) of said first group (2) of channels into one or more predetermined channels (9) of said second group (3) of channels, and
   a second connecting part (6) arranged at said second end of said heat exchanger (1; 1') and which comprises the second fluid distribution element (21) which is arranged to conduct fluid from one or more channels (9) into one or more channels (9) of the same group (2, 3) of channels,
   wherein the first and second fluid distribution elements (11, 21) consists of a plurality of plates (12 - 16; 22, 23) arranged on top of each other, some of said plates comprising openings (17, 19; 24) for providing fluid paths between channels (9) of said at least first and second groups (2, 3) of channels.

2. A heat exchanger according to claim 1, wherein said first group (2) of channels, and respectively, said second group (3) of channels (9) consists of channels separated by internal walls of a respective pipe (10).

3. A heat exchanger according to one of claims 1 to 2, wherein said first fluid distribution element (11) comprises a channel (19) providing a fluid path between one or more predetermined channels of a group of channels located outermost on one side of the heat exchanger and one or more predetermined channels of a group (2) of channels located outermost on an opposite side of the heat exchanger.

4. A heat exchanger according to one of claims 1 to 3, wherein said second heat transfer element (8) comprises fins extending between walls of said channels (9) in order to transfer heat from said fluid in said channels (9) to the surroundings via said fins.

**Patentansprüche**

1. Wärmetauscher (1; 1'), der Folgendes umfasst:

mindestens eine erste Gruppe (2) und eine zweite Gruppe (3) von Kanälen, die so angeordnet sind, dass sie Fluidpfade zwischen einem ersten Ende und einem zweiten Ende des Wärmetauschers (1; 1') bereitstellen, wobei die Kanäle (9) kapillare Dimensionen für das genutzte Fluid aufweisen und durch ein erstes und ein zweites Fluidverteilungselement (11, 21), die Fluid aus vorher bestimmten Kanälen zwischen den unterschiedlichen Gruppen leiten, miteinander verbunden sind,

ein erstes, in der Nähe des ersten Endes angeordnetes Wärmeüberführungselement (7) mit einer Verdampferfunktion zur Überführung einer Wärmebelastung zu einem Fluid in allen Kanälen (9) der mindestens einen ersten Gruppe (2) und einen zweiten Gruppe (3) von Kanälen, wobei das erste Wärmeüberführungselement (7) eine erste Oberfläche (26) zum Empfang elektronischer Komponenten und eine zweite Oberfläche (25) mit Rillen zur Herstellung einer Verbindung mit Wänden der Kanäle (9) umfasst, um durch die elektronischen Komponenten erzeugte Wärme zum Fluid in den Kanälen (9) zu überführen,

ein zweites, in der Nähe des zweiten Endes angeordnetes Wärmeüberführungselement (8) mit einer Kondensatorfunktion zur Überführung einer Wärmebelastung vom Fluid in allen Kanälen (9) der mindestens einen ersten Gruppe (2) und einen zweiten Gruppe (3) von Kanälen,

einen ersten, am ersten Ende des Wärmetauschers (1; 1') angeordneten Verbindungteil (5), der das erste Fluidverteilungselement (11) umfasst, das so angeordnet ist, dass es Fluid aus einem oder mehreren vorher bestimmten Kanälen (9) der ersten Gruppe (2) von Kanälen in einen oder mehrere vorher bestimmte Kanäle (9) der zweiten Gruppe (3) von Kanälen leitet, und einen zweiten, am zweiten Ende des Wärmetauschers (1; 1') angeordneten Verbindungteil (6), der das zweite Fluidverteilungselement (21) umfasst, das so angeordnet ist, dass es Fluid aus einem oder mehreren Kanälen (9) in einen oder mehrere Kanäle (9) derselben Gruppe (2, 3) von Kanälen leitet,

wobei das erste und das zweite Fluidverteilungselement (11, 21) aus einer Vielzahl von übereinander angeordneten Platten (12-16; 22, 23) bestehen, wobei einige der Platten Öffnungen (17, 19; 24) zum Bereitstellen von Fluidpfaden zwischen Kanälen (9) der mindestens einen ersten und einen zweiten Gruppe (2, 3) von Kanälen umfassen.

2. Wärmetauscher nach Anspruch 1, wobei die erste Gruppe (2) von Kanälen bzw. die zweite Gruppe (3) von Kanälen (9) aus Kanälen, die durch innere Wände eines jeweiligen Rohrs (10) getrennt sind, besteht.

3. Wärmetauscher nach einem der Ansprüche 1 bis 2, wobei das erste Fluidverteilungselement (11) einen Kanal (19) umfasst, der einen Fluidpfad zwischen einem oder mehreren vorher bestimmten Kanälen einer Gruppe von Kanälen, die sich am weitesten außen auf einer Seite des Wärmetauschers befinden, und einem oder mehreren vorher bestimmten Kanälen einer Gruppe (2) von Kanälen, die sich am weitesten außen auf einer gegenüberliegenden Seite des Wärmetauschers befinden, bereitstellt.

4. Wärmetauscher nach einem der Ansprüche 1 bis 3, wobei das zweite Wärmeüberführungselement (8) sich zwischen Wänden der Kanäle (9) erstreckende Rippen umfasst, um Wärme vom Fluid in den Kanälen (9) über die Rippen in die Umgebung zu überführen.

**Revendications**

1. Échangeur (1 ; 1') de chaleur comportant :

au moins un premier groupe (2) et un deuxième groupe (3) de canaux agencés pour ménager des parcours de fluide entre une première extrémité et une deuxième extrémité dudit échangeur (1 ; 1') de chaleur, lesdits canaux (9) étant dimensionnés de façon capillaire pour le fluide utilisé et reliés l'un à l'autre par un premier et un deuxième élément (11, 21) de distribution de fluide acheminant du fluide à partir de canaux prédéterminés entre les différents groupes,

un premier élément (7) de transfert de chaleur agencé au voisinage de ladite première extrémité pour fonctionner en tant qu'évaporateur servant à transférer une charge thermique à du fluide présent dans tous les canaux (9) d'au moins lesdits premier (2) et deuxième (3) groupes de canaux, ledit premier élément (7) de transfert de chaleur comportant une première surface (26) destinée à recevoir des composants électroniques et une deuxième surface (25) dotée de rainures, destinée à toucher des parois desdits canaux (9) afin de transférer de la chaleur générée par lesdits composants électroniques audit fluide présent dans lesdits canaux (9),

un deuxième élément (8) de transfert de chaleur agencé au voisinage de ladite deuxième extrémité pour fonctionner en tant que condenseur servant à transférer une charge thermique hors dudit fluide présent dans tous les canaux (9) d'au moins lesdits premier (2) et deuxième (3) groupes de canaux,

une première partie (5) de raccordement agencée à ladite première extrémité dudit échangeur (1 ; 1') de chaleur et qui comporte le premier élément (11) de distribution de fluide qui est agencé pour acheminer du fluide provenant d'un ou plusieurs canaux prédéterminés (9) dudit premier groupe (2) de canaux jusque dans un ou plusieurs canaux (9) prédéterminés dudit deuxième groupe (3) de canaux, et

une deuxième partie (6) de raccordement agencée à ladite deuxième extrémité dudit échangeur (1 ; 1') de chaleur et qui comporte le deuxième élément (21) de distribution de fluide qui est agencé pour acheminer du fluide provenant d'un ou plusieurs canaux (9) jusque dans un ou plusieurs canaux (9) du même groupe (2, 3) de canaux,

les premier et deuxième éléments (11, 21) de distribution de fluide consistant en une pluralité de plaques (12-16 ; 22, 23) agencées les unes sur les autres, certaines desdites plaques comportant des ouvertures (17, 19 ; 24) destinées à ménager des parcours de fluide entre des canaux (9) d'au moins lesdits premier et deuxième groupes (2, 3) de canaux.

2. Échangeur de chaleur selon la revendication 1, ledit premier groupe (2) de canaux et, respectivement, ledit deuxième groupe (3) de canaux (9) consistant en canaux séparés par des parois internes d'une conduite (10) respective.

3. Échangeur de chaleur selon l'une des revendications 1 à 2, ledit premier élément (11) de distribution de fluide comportant un canal (19) ménageant un parcours de fluide entre un ou plusieurs canaux prédéterminés d'un groupe de canaux situés le plus à l'extérieur sur un côté de l'échangeur de chaleur et un ou plusieurs canaux prédéterminés d'un groupe (2) de canaux situés le plus à l'extérieur sur un côté opposé de l'échangeur de chaleur.

4. Échangeur de chaleur selon l'une des revendications 1 à 3, ledit deuxième élément (8) de transfert de chaleur comportant des ailettes s'étendant entre des parois desdits canaux (9) afin de transférer de la chaleur dudit fluide présent dans lesdits canaux (9) au milieu environnant via lesdites ailettes.

FIG. 1

FIG. 2

FIG. 3

FIG. 4

28

28

27

27

FIG. 5

1'

8

7'

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2031332 A
- EP 2327947 A
- WO 03054467 A1
- WO 2010055542 A2